# FASCICULE DE BREVET EUROPEEN

(11) **EP 3 608 678 B1**
(45) Date de publication et mention de la délivrance du brevet: **07.06.2023**
(21) Numéro de dépôt: 19180470.7
(22) Date de dépôt: 17.06.2019
(51) Int. Cl.: G01R 15/18, H01F 38/28, H02H 3/33, H02H 3/347

(54) **DISPOSITIF DE DETECTION D'UN COURANT ELECTRIQUE CONTINU OU ALTERNATIF, MODULE ET APPAREIL DE PROTECTION COMPORTANT UN TEL DISPOSITIF**
DETEKTIONSVORRICHTUNG EINES ELEKTRISCHEN GLEICH- ODER WECHSELSTROMS, MODUL UND SCHUTZGERÄT, DIE EINE SOLCHE VORRICHTUNG UMFASSEN
DEVICE FOR DETECTING A CONTINUOUS OR ALTERNATING ELECTRICAL CURRENT, PROTECTIVE MODULE AND PROTECTIVE APPARATUS COMPRISING SUCH A DEVICE

(30) Priorité: 09.08.2018 FR 1857404
(43) Date de publication de la demande: 12.02.2020
(73) Titulaire: Schneider Electric Industries SAS, 92500 Rueil Malmaison (FR)
(72) Inventeur: STEPANEK, Jiri, 38050 Grenoble (FR); CADOUX, Yvan, 38050 Grenoble (FR)
(74) Mandataire: Schneider Electric

(56) Documents cités:
- EP-A1- 0 349 880
- EP-A1- 3 232 526
- EP-A2- 0 590 435
- EP-A2- 2 765 665

## Description

### DOMAINE TECHNIQUE

La présente invention concerne un dispositif de détection d'un courant électrique, continu ou alternatif circulant dans une ligne de courant d'une installation électrique en raison d'un défaut d'isolement dans l'installation.

L'invention concerne également un module de protection contre un défaut électrique ainsi qu'un appareil de protection électrique.

### ETAT DE LA TECHNIQUE

Des dispositifs de détection d'un courant de défaut sont utilisés très largement dans les installations électriques alimentées par des réseaux alternatifs. Leur fonction est de détecter tout courant de défaut, appelé aussi courant de fuite, circulant généralement entre le réseau électrique et la terre ou la masse de l'installation. Un courant de défaut est la manifestation d'un défaut d'isolement du réseau par rapport à la terre et doit être éliminé avant que des dommages puissent avoir lieu. Ces dispositifs font partie des installations électriques industrielles ou domestiques.

Avec le développement des charges électroniques, par exemple les stations de recharge de véhicules électriques ou la production d'électricité par des panneaux photovoltaïques, la nature des courants de défaut a changé : la présence de redresseurs électroniques, de convertisseurs de tension ou de fréquence est à l'origine de l'apparition de courants de défaut continus ou pulsés. Il est donc nécessaire d'installer des dispositifs de protection adaptés à la détection de tout type de courant alternatif, continu ou pulsé. De tels dispositifs doivent être capables de détecter un courant de défaut d'amplitude faible pour protéger les personnes, par exemple un courant d'amplitude 30 mA à la fréquence du réseau électrique 50 Hz, tout en étant capables de détecter des courants d'amplitude élevée à haute fréquence. De plus, de tels dispositifs doivent rester opérationnels quand l'amplitude du courant dépasse une limite haute, quelle que soit la fréquence du courant à détecter, afin de générer une alerte et éventuellement activer une déconnexion de la portion de circuit électrique en défaut.

La demande de brevet EP 0 356 248 A1 décrit un capteur de courant continu fonctionnant selon une technologie « fluxgate » basée sur une saturation contrôlée d'un noyau magnétique. Ce type de capteur a la capacité de détecter des courants continus ou alternatifs, de faible intensité, sur une bande de fréquence relativement large. Cependant, au-dessus d'un niveau d'amplitude donné, le courant à mesurer perturbe la saturation contrôlée du noyau magnétique ce qui rend la détection inopérante.

Le document DE 101 28 311 A1 décrit un capteur de courant continu utilisant deux circuits magnétiques : un premier circuit magnétique est utilisé comme un transformateur du courant à mesurer, un second circuit magnétique est utilisé pour soustraire au signal de mesure un signal composé des composantes haute fréquence et déphasées de 180° issue dudit courant à mesurer. Un tel capteur permet de détecter un courant dans une bande de fréquences allant du continu jusqu'à 10 kHz et d'amplitude comprise entre 10 mA et 400 mA.

La demande de brevet EP 1 533 880 A1 décrit un capteur de courant de défaut, utilisant un circuit magnétique dont la fréquence d'excitation peut être changée afin d'éviter un phénomène de résonnance quand le courant de défaut contient des fréquences supérieures à la moitié de la fréquence d'excitation.

La demande de brevet EP 3 232 526 A1 décrit un dispositif de détection d'un courant de défaut disposant d'une détection de la saturation d'un circuit magnétique par des courants haute fréquence superposés sur le courant de défaut.

La demande de brevet EP 2 765 665 A2 décrit un dispositif pour détecter des courants électriques différentiels, comportant un circuit oscillant conçu au moyen d'un générateur de signal carré.

L'invention a pour objet un dispositif de détection de courant continu ou alternatif capable de détecter des courants dans des plages d'amplitude et de fréquence plus larges que celles atteignables en suivant les documents de l'art antérieur.

### EXPOSE DE L'INVENTION

Pour cela, l'invention a pour objet un dispositif de détection d'un courant électrique continu ou alternatif comportant :
- un capteur de courant continu comprenant :
   - un premier circuit magnétique traversé par, au moins, un conducteur de courant dans lequel circule le courant électrique de défaut à détecter, ledit conducteur de courant formant un premier circuit primaire,
   - un premier enroulement bobiné sur ledit premier circuit magnétique pour former un premier circuit secondaire et fournir un premier signal représentatif du courant de défaut, et
   - un générateur connecté aux bornes du premier enroulement pour générer un courant alternatif d'excitation du premier circuit magnétique et induire un champ magnétique dans le premier circuit magnétique, ledit générateur étant agencé pour que ledit champ magnétique sature alternativement dans un sens donné puis en sens inverse le premier circuit magnétique, et
- un circuit de mesure du courant,
- un capteur de courant alternatif comportant un second circuit magnétique sur lequel est bobiné un second enroulement pour fournir un second signal représentatif du courant de défaut circulant dans le conducteur de courant, ledit second enroulement étant connecté en série avec le premier enroulement de sorte que le premier signal et le second signal représentatifs du courant de défaut circulant dans le conducteur de courant sont en phase, et avec le circuit de mesure du courant, le second circuit magnétique étant traversé par le conducteur de courant dans lequel circule le courant électrique de défaut, ledit conducteur de courant formant un second circuit primaire.

Avantageusement, le premier circuit primaire comportant un premier nombre de spires primaires, le premier enroulement comportant un premier nombre de spires secondaires, le second circuit primaire comportant un second nombre de spires primaires et le second enroulement comportant un second nombre de spires secondaires, le rapport du premier nombre de spires primaires sur le premier nombre de spires secondaires est sensiblement égal au rapport du second nombre de spires primaires sur le second nombre de spires secondaires.

De préférence, le circuit de mesure du courant comprend une résistance de mesure pour fournir un signal de mesure.

Avantageusement, le second enroulement et la résistance de mesure sont agencés pour former un premier filtre passe-bas de fréquence de coupure comprise entre 1 et 1000 Hz.

Avantageusement, un second filtre passe-bas est connecté au circuit de mesure du courant pour fournir un signal filtré représentatif de la composante basse fréquence du courant de défaut.

Préférentiellement, le second filtre passe-bas filtre les fréquences de façon à suivre un gabarit de sensibilité humaine au courant électrique.

De préférence, le second filtre passe-bas a une fréquence de coupure comprise entre 30 et 300 Hz.

Avantageusement, un premier comparateur est connecté en sortie du second filtre passe-bas pour délivrer un premier signal de défaut quand le signal filtré est supérieur à un premier seuil.

Avantageusement, un circuit de mesure de niveau de signal est connecté au circuit de mesure du courant pour fournir un signal représentatif du niveau maximal du signal de mesure.

Avantageusement, un second comparateur est connecté en sortie du circuit de mesure de niveau de signal pour délivrer un deuxième signal de défaut quand le niveau maximal du signal délivré par le second comparateur est supérieur à un deuxième seuil.

Avantageusement, un circuit de détection de fréquence anormale est connecté au premier enroulement pour mesurer les composantes fréquentielles du courant alternatif d'excitation et fournir un troisième signal de défaut quand au moins une composante fréquentielle dudit courant alternatif d'excitation est comprise entre une fréquence limite basse et une fréquence limite haute prédéfinies.

Préférentiellement, la fréquence limite basse est comprise entre 1kHz et 10 kHz et la fréquence limite haute est comprise entre 20 kHz et 200 kHz.

Avantageusement, le capteur de courant continu comporte au moins un régulateur shunt de tension pour écrêter une élévation de tension aux bornes du premier enroulement quand le courant de défaut circulant dans le conducteur de courant dépasse une amplitude crête prédéfinie.

L'invention a également pour objet un module de protection contre un défaut électrique comportant :
- au moins une borne de raccordement amont à une ligne de courant d'un réseau électrique et au moins une borne de raccordement aval à une ligne de distribution d'énergie,
- au moins un conducteur de courant connecté entre la borne de raccordement amont et la borne de raccordement aval,
- un dispositif de détection d'un courant électrique de défaut circulant dans le au moins un conducteur de courant tel que décrit précédemment, et
- un module de traitement connecté :
   - à un premier comparateur pour recevoir un premier signal de défaut,
   - à un second comparateur pour recevoir un deuxième signal de défaut, et
   - à un circuit de détection de fréquence anormale pour recevoir un troisième signal de défaut,
   ledit module de traitement étant agencé pour fournir un signal d'alerte ou de commande quand ledit module de traitement reçoit un premier ou un deuxième ou un troisième signal de défaut.

L'invention porte également sur un appareil de protection électrique comportant :
- au moins un élément de raccordement au réseau électrique et au moins un élément de raccordement à une ligne de distribution d'énergie,
- un interrupteur électrique, connecté en série avec, au moins, un conducteur de courant, entre l'élément de raccordement au réseau électrique et l'élément de raccordement à la ligne de distribution d'énergie, ledit interrupteur électrique étant agencé pour permettre ou interrompre une circulation d'un courant électrique de défaut, continu ou alternatif, dans le, au moins un, conducteur de courant,
- un mécanisme de commande d'ouverture de l'interrupteur électrique,
- un actionneur agencé pour actionner le mécanisme de commande d'ouverture, et
- un module de protection contre un défaut électrique tel que décrit précédemment pour détecter un courant électrique de défaut circulant dans le au moins un conducteur de courant, ledit module électrique de protection étant connecté à l'actionneur pour commander l'ouverture de l'interrupteur électrique quand un signal d'alerte ou de commande est fourni par le module de protection.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 illustre, sous forme de schéma bloc, un dispositif de détection d'un courant électrique selon l'invention,
- la figure 2 représente un schéma détaillé d'un mode de réalisation d'un capteur de courant continu associé à un capteur de courant alternatif et à un circuit de mesure,
- la figure 3 représente un schéma détaillé d'un écrêteur de tension adapté au capteur de courant continu représenté sur la figure 2,
- la figure 4 illustre des zones de fonctionnement du dispositif de détection de courant en fonction de la fréquence et de l'amplitude du courant à détecter,
- la figure 5 représente, sous forme de schéma bloc, un module de protection contre un défaut électrique, et
- la figure 6 représente un schéma bloc d'un appareil de protection électrique.

### DESCRIPTION DETAILLEE DE MODES DE REALISATION PREFERES

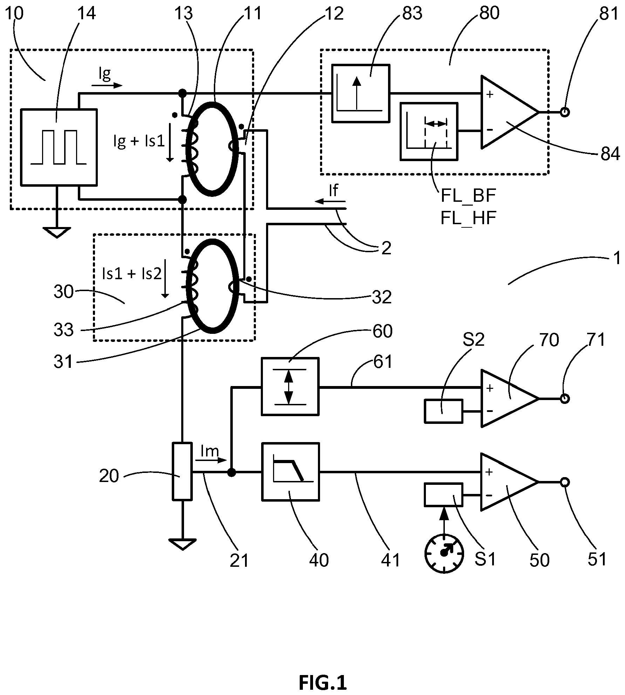

La figure 1, illustre, sous forme de schéma bloc, un dispositif de détection 1 d'un courant électrique continu ou alternatif circulant dans un conducteur de courant 2. Le dispositif de détection 1 étant préférentiellement destiné à détecter un courant différentiel de défaut If dans une installation électrique, le conducteur de courant 2 symbolise deux conducteurs ou barres de cuivre d'un jeu de barres dans le cas d'une installation monophasée, le conducteur de courant 2 symbolise au moins trois conducteurs de phase et éventuellement un conducteur de neutre dans une installation triphasée. Le courant détecté est alors un courant appelé « courant différentiel ». Le dispositif de détection 1 comporte un capteur de courant continu 10 connecté en série avec un transformateur de courant alternatif 30 et un circuit de mesure du courant 20, ledit circuit de mesure du courant étant connecté en série avec le transformateur de courant alternatif 30. L'ensemble formé par le capteur de courant continu 10, le capteur de courant alternatif 30 et le circuit de mesure 20 permet de détecter et mesurer un courant comportant une composante continue et/ou une ou plusieurs composantes alternatives.

Le capteur de courant continu 10 comprend :
- un premier circuit magnétique 11 traversé par le conducteur de courant 2 dans lequel circule le courant de défaut If à détecter, ledit conducteur de courant 2 formant un premier circuit primaire 12,
- un premier enroulement 13 bobiné sur ledit premier circuit magnétique 11 pour former un premier circuit secondaire et fournir un premier signal Is1 représentatif du courant de défaut If circulant dans le conducteur de courant 2,
- un générateur 14 connecté aux bornes du premier enroulement 13 pour générer un courant alternatif d'excitation Ig du premier circuit magnétique 11.

Le générateur 14 délivre un signal électrique alternatif de fréquence d'oscillation Fosc créant un courant d'excitation Ig alternatif appliqué au premier enroulement 13. Le courant d'excitation Ig induit un champ magnétique dans le premier circuit magnétique 11. Le générateur 14 est agencé pour que le champ magnétique sature alternativement dans un sens donné puis en sens inverse le premier circuit magnétique 11. En présence du courant de défaut If circulant dans conducteur de courant 2, il se produit un décalage du champ magnétique dans le circuit magnétique 11 donnant naissance à un premier signal Is1 représentatif du courant de défaut If, superposé au courant d'excitation Ig délivré par le générateur. Ce principe de fonctionnement présente un inconvénient quand le courant de défaut If à détecter comporte des harmoniques de fréquence supérieures à la fréquence d'oscillation Fosc. En effet, la saturation du premier circuit magnétique 11 a pour conséquence un effet d'échantillonnage et on peut observer un phénomène de repliement de spectre pour les fréquences supérieures à la fréquence d'oscillation Fosc contenues dans le courant de défaut If. Il est donc impératif de filtrer fortement les composantes harmoniques supérieures à la fréquence d'oscillation Fosc.

Le capteur de courant alternatif 30 comporte un second circuit magnétique 31 traversé par le conducteur de courant 2 dans lequel circule le courant électrique à détecter If, ledit conducteur de courant 2 formant un second circuit primaire 32. Un second enroulement 33 est bobiné sur le second circuit magnétique 31 pour fournir un second signal Is2. Par principe, le second signal Is2 est représentatif des composantes alternatives contenues dans le courant de défaut If, le capteur de courant alternatif 30 se comportant comme un transformateur de courant. Le second enroulement 33 est connecté en série avec le premier enroulement 13 et avec le circuit de mesure du courant 20. De cette façon, le circuit de mesure 20 mesure un signal formé de la superposition du premier signal Is1 et du second signal Is2. Le générateur 14 étant connecté aux bornes du premier enroulement 13, le courant d'excitation Ig se reboucle par le générateur 14 et ainsi ne circule pas dans le circuit de mesure 20.

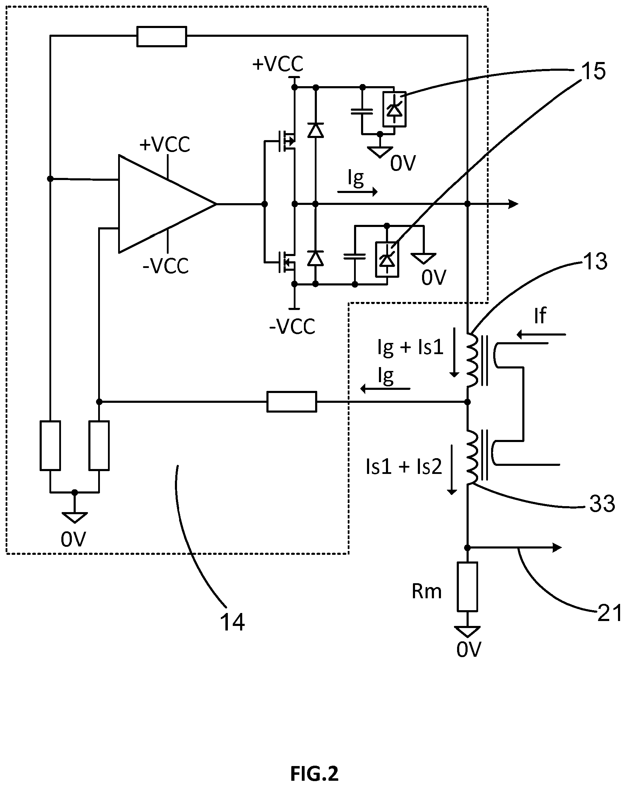

Le premier capteur de courant 10 est agencé pour détecter la composante continue et les composantes basses fréquences contenues dans le courant de défaut If. Cependant le premier circuit magnétique 11, le premier circuit primaire 12 et le premier enroulement 13 forment un transformateur de courant pour les courants alternatifs. Cet effet est généralement considéré comme un inconvénient du premier capteur lié au phénomène de repliement de spectre décrit précédemment. Pour réduire les effets liés au repliement de spectre, le premier enroulement 13 et le second enroulement 33 sont connectés de sorte que le premier signal Is1 et le second signal Is2 soient en phase. Le sens de bobinage des enroulements est repéré par un point sur la figure 1. De cette façon, pour une alternance positive du courant de défaut If, le premier signal Is1 et le second signal Is2, représentatifs du courant de défaut If, seront eux aussi positifs. Il en est de même pour une alternance négative du courant de défaut If. De plus, le premier circuit primaire 12 comportant un premier nombre de spires primaires Np1, le premier enroulement 13 comportant un premier nombre de spires secondaires Ns1, le second circuit primaire 32 comportant un second nombre de spires primaires Np2 et le second enroulement 33 comportant un second nombre de spires secondaires Ns2, le rapport du premier nombre de spires primaires Np1 sur le premier nombre de spires secondaires Ns1 est sensiblement égal au rapport du second nombre de spires primaires Np2 sur le second nombre de spires secondaires Ns2 soit Np1/Ns1 ≈ Np2/Ns2. Préférentiellement, le rapport Np1/Ns1 est égal au rapport Np2/Ns2 pour obtenir une égalité du premier signal Is1 et du second signal Is2 pour un courant de défaut If donné. Un écart peut être donné entre le rapport Np1/Ns1 et le rapport Np2/Ns2 pour ajuster l'égalité du premier signal Is1 et du second signal Is2 dans une bande de fréquence donnée. En effet, la composition des premier et second circuits magnétiques 11, 31 peut différer apportant ainsi des réponses en fréquence différentes entre le capteur de courant continu 10 et le capteur de courant alternatif 30. L'expression « sensiblement égal » correspond à un écart compris entre 0 % et 10 % entre le rapport Np1/Ns1 et le rapport Np2/Ns2. La figure 2 représente un schéma détaillé du capteur de courant continu 10, du capteur de courant alternatif 30 et du circuit de mesure 20. Le premier enroulement 13 est parcouru par le courant d'excitation Ig auquel s'ajoute le premier signal Is1. Le second enroulement 33 est parcouru par les courants Is1 et Is2. Le générateur 14 connecté aux bornes du premier enroulement 13 a pour rôle la circulation du courant Ig dans le premier enroulement 13, et, par conséquent, le courant Ig ne circule pas dans le second enroulement 33. Réciproquement, le premier signal Is1 étant sensiblement égal au second signal Is2, il ne circule pas de courant résultant d'un écart entre Is1 et Is2 dans le générateur 14. Cet effet technique de l'invention réduit l'influence des perturbations en fréquence apportées par le courant de défaut If sur le générateur 14.

Le circuit de mesure du courant 20 peut être un convertisseur courant-tension. Cependant un tel convertisseur dispose d'une dynamique de mesure limitée par la tension d'alimentation des circuits qui la composent. Préférentiellement, le circuit de mesure du courant 20 comprend une résistance de mesure Rm pour fournir un signal de mesure 21. La résistance de mesure Rm, parcourue par le premier signal Is1 et le second signal Is2, fournit une tension à l'image du courant qui la traverse, sans présenter de saturation, même à fort niveau de courant. De plus, la résistance de mesure Rm connectée en série avec le second enroulement 33, forme astucieusement un premier filtre passe-bas de type L-R, le second enroulement 33 bobiné sur le second circuit magnétique 31 se comportant comme une inductance vis-à-vis du premier signal Is1. Ainsi, les composantes à hautes fréquences, incluant la fréquence d'oscillation Fosc, seront éliminées et seule la composante continue et les basses fréquences contenues dans le premier signal Is1 seront mesurées par le circuit de mesure 20. La fréquence de coupure dudit premier filtre passe-bas est comprise entre 1 et 1000 Hz. Ladite fréquence de coupure peut varier fortement à cause de la variabilité de l'inductance du second enroulement 33, très liée à la variabilité des caractéristiques du matériau magnétique composant le second circuit magnétique 31. Pour réduire cette variabilité, un second filtre passe-bas 40 est connecté au circuit de mesure du courant 20 pour fournir un signal filtré 41 représentatif de la composante basse fréquence du courant de défaut If. Préférentiellement le second filtre passe-bas 40 filtre les fréquences de façon à suivre un gabarit de sensibilité humaine au courant électrique. Ce gabarit impose une haute sensibilité, par exemple 30 mA, à une fréquence réseau F1 égale à 50 Hz ou 60 Hz, et une sensibilité moindre aux fréquences plus élevées, par exemple 100 mA à 400 Hz. De préférence, le second filtre passe-bas 40 a une fréquence de coupure Fc1 comprise entre 30 et 300 Hz.

Un premier comparateur 50 est connecté en sortie du second filtre passe-bas 40 pour délivrer un premier signal de défaut 51 quand le signal filtré 41 est supérieur à un premier seuil S1. Ledit premier seuil S1 est prédéfini et permet d'utiliser le dispositif de détection faisant l'objet de l'invention pour protéger les biens et les personnes contre un défaut d'origine électrique. Par exemple, un premier seuil S1 fixé à 30 mA permet d'émettre le premier signal de défaut pour protéger toute personne d'un contact avec une partie accessible d'un équipement mise accidentellement sous tension. Le premier seuil S1 peut également être fixé à 300 mA pour une protection contre les risques d'incendie d'origine électrique. Le premier seuil S1 est préférentiellement réglable entre 10 mA et 1A.

Un courant de défaut, par exemple d'amplitude 10 ampères et de fréquence 10 kHz, même s'il est hors gabarit de sensibilité humaine au courant électrique, peut être à l'origine d'un départ d'incendie. C'est pourquoi un circuit de mesure de niveau de signal 60 est connecté au circuit de mesure du courant 20 pour fournir un signal représentatif du niveau maximal 61 du signal de mesure 21. Un second comparateur 70 est connecté en sortie du circuit de mesure de niveau de signal 60 pour délivrer un deuxième signal de défaut 71 quand le niveau maximal du signal délivré par le second comparateur 70 est supérieur à un deuxième seuil S2. Le deuxième seuil S2 est préférentiellement compris entre 1 et 10 ampères. Le circuit de mesure de niveau de signal 60 fonctionne parallèlement et indépendamment de la chaîne de traitement comportant le second filtre passe-bas 40 et le premier comparateur 50.

Le fonctionnement du générateur 14 du premier capteur de courant 10 peut être perturbé par un courant intense, continu ou à très basse fréquence, causé, par exemple, par un défaut d'isolement dans une charge électronique telle qu'un variateur de vitesse. Un tel courant sature d'une façon non contrôlée le matériau magnétique du premier circuit magnétique ce qui conduit le générateur 14 à fonctionner à une fréquence Fosc très différente de sa fréquence nominale de fonctionnement, tout particulièrement quand le générateur 14 est auto-oscillant. Pour détecter toute excursion anormale de la fréquence d'oscillation Fosc, un circuit de détection de fréquence anormale 80 est connecté au premier enroulement 13 pour mesurer les composantes fréquentielles du courant alternatif de saturation. Ledit circuit de détection de fréquence anormale 80 comporte un circuit de mesure de fréquence 83, connecté au générateur 14, pour mesurer la fréquence Fosc du générateur et un troisième comparateur 84, connecté au circuit de mesure de fréquence 83, pour comparer la valeur de la fréquence mesurée Fosc à une fréquence limite basse FL_BF et à une fréquence limite haute FL_HF. Le troisième comparateur 84 délivre un troisième signal de défaut 81 quand la valeur de la fréquence Fosc est comprise entre la fréquence limite basse FL_BF et la fréquence limite haute FL_HF prédéfinies. Préférentiellement, la fréquence limite basse FL_BF est comprise entre 1kHz et 10 kHz et la fréquence limite haute FL_HF est comprise entre 20 kHz et 200 kHz.

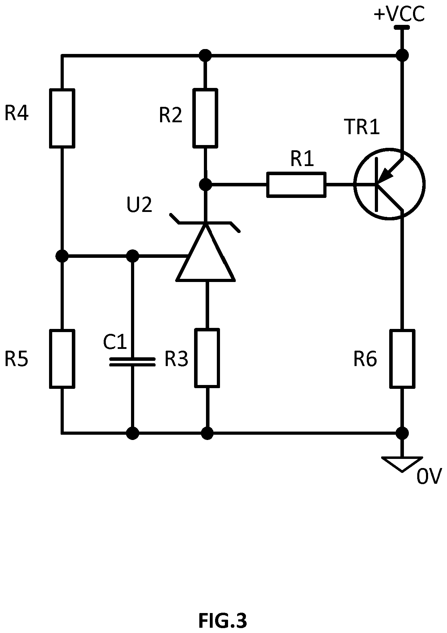

La tenue du dispositif de détection de courant 1 est encore améliorée par la mise en oeuvre d'un régulateur shunt de tension 15 pour écrêter toute élévation de tension de l'alimentation du générateur 14 causée par une élévation de la tension aux bornes du premier enroulement 13 quand le courant de défaut If circulant dans le conducteur de courant 2 dépasse une amplitude crête prédéfinie Icrête. Le régulateur shunt 15 a pour effet de diminuer la résistance de charge du transformateur de courant formé par le premier circuit magnétique 11, le premier circuit primaire 12 et le premier enroulement 13. Sur le schéma détaillé du premier capteur de courant représenté en figure 2, un premier régulateur shunt 15 est connecté entre une alimentation positive +Vcc et un potentiel de référence, un second régulateur shunt 15 est connecté entre une alimentation négative -Vcc et le potentiel de référence. La figure 3 représente un schéma détaillé d'un régulateur shunt 15. Une référence de tension U2, par exemple un circuit portant la référence TL431 du fabricant Texas Instruments, fixe un potentiel de référence, par exemple 2,75 Volt. Quand l'alimentation positive +Vcc tend à augmenter, un transistor TR1, de type PNP, dont l'émetteur est connecté à l'alimentation positive +Vcc et dont la base est connectée à la référence de tension, se met à conduire ce qui tend à augmenter le courant dans son collecteur. Le premier enroulement 13 à l'origine de la surtension doit donc fournir plus de courant tant que la tension +Vcc dépasse sa valeur nominale et reste ainsi dans un mode de transformateur de courant. De cette façon, pour un courant de défaut If donné, même très au-dessus du premier seuil S1 ou du deuxième seuil S2, le premier signal Is1 reste sensiblement égal au second signal Is2, le premier circuit magnétique 11 n'est pas saturé par le courant de défaut If. Une première résistance R1 limite le courant dans la base du transistor TR1, une seconde résistance R23 et une troisième résistance R3 connectée en série avec la référence de tension U2 limitent le courant d'alimentation de la référence de tension U2. Un pont diviseur formé d'une quatrième résistance R4 et d'une cinquième résistance R5 fournit une image de la tension +Vcc à la référence de tension U2. Une sixième résistance R6 limite le courant dans le collecteur du transistor TR1. Un condensateur C1 est connecté aux bornes de la cinquième résistance R5 pour filtrer les perturbations haute fréquence. D'autres modes de réalisation, par exemple utilisant une diode zener, ou un circuit « voltage regulator » de référence TPS7A3901 du fabricant Texas Instrument, peuvent être utilisés pour diminuer la résistance de charge du transformateur de courant formé par le premier circuit magnétique 11, le premier circuit primaire 12 et le premier enroulement 13 et ainsi augmenter la plage d'amplitude de courant détecté par le dispositif de détection 1.

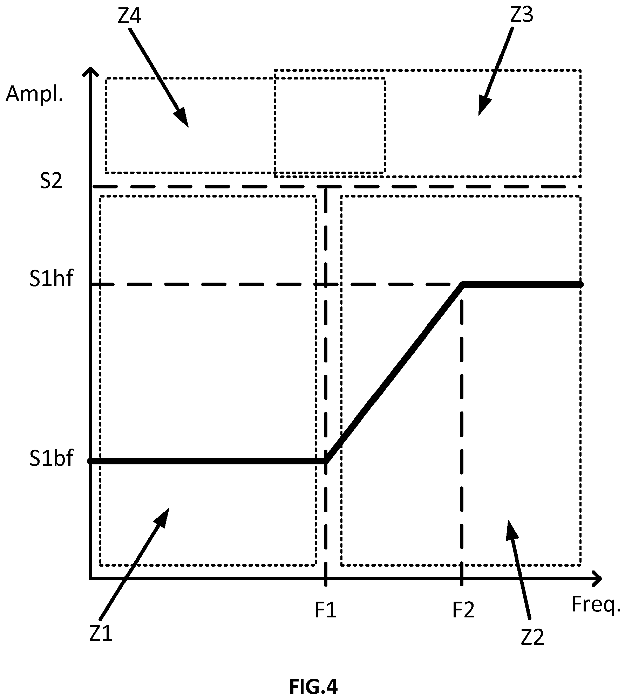

La figure 4 illustre les zones de fonctionnement du dispositif de détection de courant en fonction de la fréquence et de l'amplitude du courant de défaut If. Le capteur de courant continu 10 est opérationnel dans une première zone Z1 basse fréquence, faible intensité. Cette première zone contient les fréquences comprises entre 0 et la fréquence réseau F1 et les intensités comprises entre 0 et le deuxième seuil S2. Le capteur de courant alternatif 30 est opérationnel dans une deuxième zone Z2 correspondant à une fréquence supérieure à la fréquence réseau F1 et une intensité inférieure au deuxième seuil S2. Le circuit de mesure de niveau de signal 60 et le second comparateur 70 sont actifs dans une troisième zone Z3 correspondant à une fréquence supérieure à la fréquence réseau F1 et une intensité supérieure au deuxième seuil S2. Le circuit de détection de fréquence anormale 80 est actif dans une quatrième zone Z4 correspondant à une fréquence inférieure à la fréquence réseau F1 et une intensité supérieure au deuxième seuil S2. Les troisième et quatrièmes zones Z3 et Z4 se chevauchent.

Le gabarit de sensibilité humaine au courant électrique demande une détection d'un courant de défaut supérieure à un premier seuil de sensibilité S1bf dans la bande de fréquence allant du continu jusqu'à la fréquence réseau F1 puis une détection d'un courant supérieur à un deuxième seuil de sensibilité S1hf pour une fréquence supérieure à une fréquence de transition F2. Le second filtre passe-bas 40 filtre les fréquences de façon à suivre ledit gabarit de sensibilité humaine au courant électrique. En conséquence le premier comparateur 50 fournit le premier signal de défaut 51 quand l'amplitude du signal filtré 41 est supérieure à S1 bf et la fréquence du courant de défaut If est inférieure à la fréquence réseau F1. Le premier comparateur 50 fournit également le premier signal de défaut 51 quand l'amplitude du signal filtré 41 est supérieure à S1hf et la fréquence du courant de défaut If est supérieure à la fréquence de transition F2. Le dispositif de détection 1 assure une protection des personnes au courant de défaut If, sur une très large plage de fréquence incluant le courant continu, en conformité avec la norme.

Le dispositif de détection de courant continu ou alternatif selon l'invention est capable de détecter des courants dans des plages d'amplitude et de fréquence extrêmement larges, sans zone aveugle. Dans une réalisation industrielle de l'invention, le fonctionnement des différents circuits génère un recouvrement des zones ce qui accroit la sécurité de fonctionnement du dispositif.

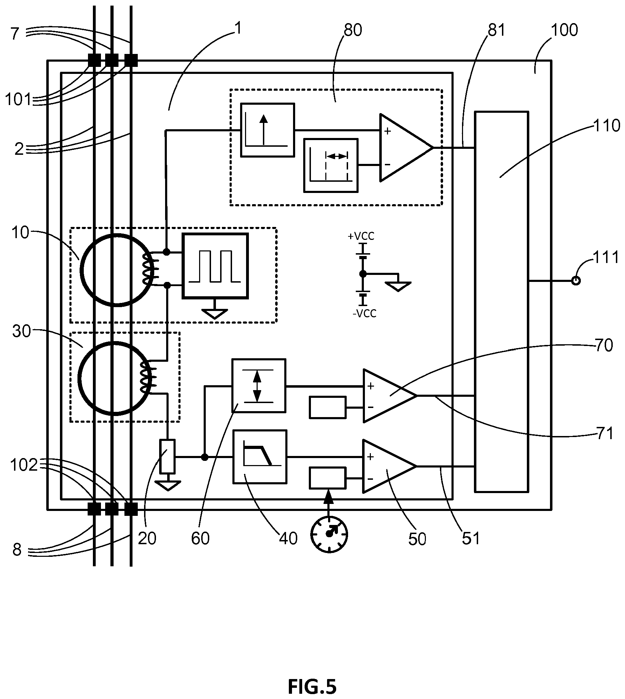

L'invention porte également sur un module de protection 100 contre un défaut électrique, représenté en figure 5 sous forme d'un schéma bloc. Ledit module comporte :
- au moins une borne de raccordement amont 101 à une ligne de courant 7 d'un réseau électrique et au moins une borne de raccordement aval 102 à une ligne de distribution d'énergie 8,
- un conducteur de courant 2 connecté entre la borne de raccordement amont 101 et la borne de raccordement aval 102,
- un dispositif de détection 1 d'un courant électrique de défaut If circulant dans le conducteur de courant 2, ledit dispositif de détection 1 étant tel que décrit précédemment,
- un module de traitement 110 connecté :
   - au premier comparateur 50 pour recevoir le premier signal de défaut 51,
   - au second comparateur 70 pour recevoir le deuxième signal de défaut 71, et
   - au circuit de détection de fréquence anormale 80 pour recevoir le troisième signal de défaut 81,

Le module de traitement 110 comporte des circuits pour traiter les premier, deuxième et troisième signaux de défaut et fournir un signal d'alerte ou de commande 111 quand un premier ou un deuxième ou un troisième signal de défaut 51, 71, 81 est actif. Le module de traitement 110 peut être réalisé au moyen de fonctions logiques câblées ou encore au moyen d'un ou plusieurs composants programmables tels que des microprocesseurs.

Le module de protection 100 est un sous-ensemble indépendant d'une installation électrique destiné à coopérer avec un organe de signalisation pour signaler la présence d'un défaut électrique ou avec un organe de déconnexion électrique pour déconnecter une portion de circuit électrique en défaut. Le module de protection 100, représenté en figure 5, est destiné à être implanté dans une installation électrique triphasée. Son fonctionnement n'est pas modifié dans le cas d'une installation monophasée ou multiphasée, seul change le nombre de bornes de raccordement 7, 8 et de conducteurs de courant 2.

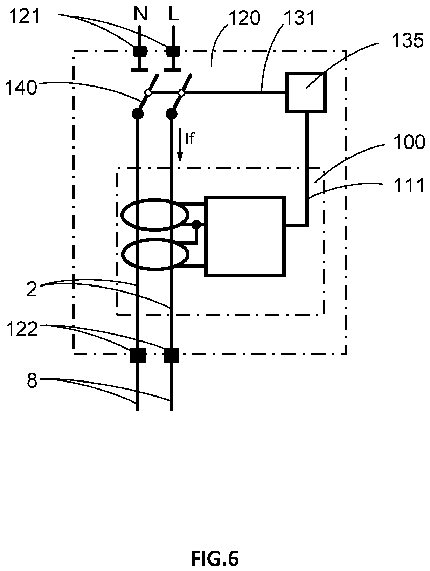

L'invention porte également sur un appareil de protection électrique 120 représenté en figure 6. Ledit appareil de protection électrique comporte :
- au moins un élément de raccordement 121 au réseau électrique et au moins un élément de raccordement 122 à une ligne de distribution d'énergie 8,
- un interrupteur électrique 140, connecté en série avec au moins un conducteur de courant 2, entre l'élément de raccordement 121 au réseau électrique et l'élément de raccordement 122 à la ligne de distribution d'énergie, ledit interrupteur électrique 140 étant agencé pour permettre ou interrompre une circulation d'un courant électrique continu ou alternatif If dans le, au moins un, conducteur de courant 2, et
- un mécanisme de commande d'ouverture 131 de l'interrupteur électrique 140,
- un actionneur 135 agencé pour actionner le mécanisme de commande d'ouverture 131, et
- un module de protection contre un défaut électrique 100 tel que décrit précédemment pour détecter un courant électrique de défaut If circulant dans le au moins un conducteur de courant 2.

Le module électrique de protection 100 est connecté à l'actionneur 135 pour commander l'ouverture de l'interrupteur électrique 140 quand un signal d'alerte ou de commande 111 est fourni par le module de protection 100. De cette façon, une portion de circuit électrique en défaut peut être déconnectée.

L'appareil de protection électrique 120, représenté en figure 6, est destiné à être implanté dans une installation électrique monophasée. Son fonctionnement n'est pas modifié dans le cas d'une installation triphasée ou multiphasée, seul change le nombre d'élément de raccordement 121, 122 et de conducteurs de courant 2.

## Revendications

1. Dispositif de détection (1) d'un courant électrique de défaut (If), continu ou alternatif, comportant :
- un capteur de courant continu (10) comprenant :
- un premier circuit magnétique (11) traversé par, au moins, un conducteur de courant (2) dans lequel circule le courant électrique de défaut (If) à détecter, ledit conducteur de courant (2) formant un premier circuit primaire (12),
- un premier enroulement (13) bobiné sur ledit premier circuit magnétique (11) pour former un premier circuit secondaire et fournir un premier signal (Is1) représentatif du courant de défaut (If), et
- un générateur (14) connecté aux bornes du premier enroulement (13) pour générer un courant alternatif d'excitation (Ig) du premier circuit magnétique (11) et induire un champ magnétique dans le premier circuit magnétique (11), et
- un circuit de mesure du courant (20), et
un capteur de courant alternatif (30) comportant un second circuit magnétique (31) sur lequel est bobiné un second enroulement (33) pour fournir un second signal (Is2) représentatif du courant de défaut (If) circulant dans le conducteur de courant (2),
**caractérisé en ce que**
ledit second enroulement (33) est connecté en série avec le premier enroulement (13) de sorte que le premier signal et le second signal (Is1, Is2) représentatifs du courant de défaut (If) circulant dans le conducteur de courant (2) sont en phase, et avec le circuit de mesure du courant (20), le second circuit magnétique (31) étant traversé par le conducteur de courant (2) dans lequel circule le courant électrique de défaut (If), ledit conducteur de courant (2) formant un second circuit primaire (32), et
ledit générateur (14) est agencé pour que ledit champ magnétique sature alternativement dans un sens donné puis en sens inverse le premier circuit magnétique (11).

2. Dispositif selon la revendication 1 **caractérisé en ce que**, le premier circuit primaire (12) comportant un premier nombre de spires primaires (Np1), le premier enroulement (13) comportant un premier nombre de spires secondaires (Ns1), le second circuit primaire (32) comportant un second nombre de spires primaires (Np2) et le second enroulement (33) comportant un second nombre de spires secondaires (Ns2), le rapport du premier nombre de spires primaires (Np1) sur le premier nombre de spires secondaires (Ns1) est sensiblement égal au rapport du second nombre de spires primaires (Np2) sur le second nombre de spires secondaires (Ns2).

3. Dispositif selon l'une des revendications précédentes **caractérisé en ce que** le circuit de mesure du courant (20) comprend une résistance de mesure (Rm) pour fournir un signal de mesure (21).

4. Dispositif selon la revendication précédente **caractérisé en ce que** le second enroulement (33) et la résistance de mesure (Rm) sont agencés pour former un premier filtre passe-bas de fréquence de coupure comprise entre 1 et 1000 Hz.

5. Dispositif selon l'une des revendications précédentes **caractérisé en ce qu'**un second filtre passe-bas (40) est connecté au circuit de mesure du courant (20) pour fournir un signal filtré (41) représentatif de la composante basse fréquence du courant de défaut (If).

6. Dispositif selon la revendication précédente **caractérisé en ce que** le second filtre passe-bas (40) filtre les fréquences de façon à suivre un gabarit de sensibilité humaine au courant électrique.

7. Dispositif selon l'une des revendications 5 ou 6 **caractérisé en ce que** le second filtre passe-bas (40) a une fréquence de coupure (Fc1) comprise entre 30 et 300 Hz.

8. Dispositif selon l'une quelconque des revendications 5 à 7 **caractérisé en ce qu'**un premier comparateur (50) est connecté en sortie du second filtre passe-bas (40) pour délivrer un premier signal de défaut (51) quand le signal filtré (41) est supérieur à un premier seuil (S1).

9. Dispositif selon l'une quelconque des revendications précédentes **caractérisé en ce qu'**un circuit de mesure de niveau de signal (60) est connecté au circuit de mesure du courant (20) pour fournir un signal représentatif du niveau maximal (61) du signal de mesure (21).

10. Dispositif selon la revendication précédente **caractérisé en ce qu'**un second comparateur (70) est connecté en sortie du circuit de mesure de niveau de signal (60) pour délivrer un deuxième signal de défaut (71) quand le niveau maximal du signal délivré par le second comparateur (70) est supérieur à un deuxième seuil (S2).

11. Dispositif selon l'une quelconque des revendications précédentes **caractérisé en ce qu'**un circuit de détection de fréquence anormale (80) est connecté au premier enroulement (13) pour mesurer les composantes fréquentielles du courant alternatif d'excitation (Ig) et fournir un troisième signal de défaut (81) quand au moins une composante fréquentielle dudit courant alternatif d'excitation (Ig) est comprise entre une fréquence limite basse (FL_BF) et une fréquence limite haute (FL_HF) prédéfinies.

12. Dispositif selon la revendication précédente **caractérisé en ce que** la fréquence limite basse (FL_BF) est comprise entre 1kHz et 10 kHz et la fréquence limite haute (FL_HF) est comprise entre 20 kHz et 200 kHz.

13. Dispositif selon l'une quelconque des revendications précédentes **caractérisé en ce que** le capteur de courant continu (10) comporte au moins un régulateur shunt de tension (15) pour écrêter une élévation de tension aux bornes du premier enroulement (13) quand le courant de défaut (If) circulant dans le conducteur de courant (2) dépasse une amplitude crête prédéfinie (Icrête).

14. Module de protection contre un défaut électrique (100) comportant :
- au moins une borne de raccordement amont (101) à une ligne de courant (7) d'un réseau électrique et au moins une borne de raccordement aval (102) à une ligne de distribution d'énergie (8),
**caractérisé en ce qu'**il comporte :
- au moins un conducteur de courant (2) connecté entre la borne de raccordement amont (101) et la borne de raccordement aval (102),
- un dispositif de détection (1) d'un courant électrique de défaut (If) circulant dans le au moins un conducteur de courant (2) selon l'une quelconque des revendications 1 à 13, et
- un module de traitement (110) connecté :
- à un premier comparateur (50) pour recevoir un premier signal de défaut (51),
- à un second comparateur (70) pour recevoir un deuxième signal de défaut (71), et
- à un circuit de détection de fréquence anormale (80) pour recevoir un troisième signal de défaut (81),
ledit module de traitement (110) étant agencé pour fournir un signal d'alerte ou de commande (111) quand ledit module de traitement (110) reçoit un premier ou un deuxième ou un troisième signal de défaut (51, 71, 81).

15. Appareil de protection électrique (120) comportant :
- au moins un élément de raccordement (121) au réseau électrique et au moins un élément de raccordement (122) à une ligne de distribution d'énergie (8),
- un interrupteur électrique (140), connecté en série avec, au moins, un conducteur de courant (2), entre l'élément de raccordement (101) au réseau électrique et l'élément de raccordement (102) à la ligne de distribution d'énergie, ledit interrupteur électrique (140) étant agencé pour permettre ou interrompre une circulation d'un courant électrique de défaut (If), continu ou alternatif, dans le, au moins un, conducteur de courant (2),
- un mécanisme de commande d'ouverture (131) de l'interrupteur électrique (140), et
- un actionneur (135) agencé pour actionner le mécanisme de commande d'ouverture (131),
**caractérisé en ce que** ledit appareil de protection électrique (120) comporte un module de protection contre un défaut électrique (100) selon la revendication précédente pour détecter un courant électrique de défaut (If) circulant dans le au moins un conducteur de courant (2), ledit module électrique de protection (100) étant connecté à l'actionneur (135) pour commander l'ouverture de l'interrupteur électrique (140) quand un signal d'alerte ou de commande (111) est fourni par le module de protection (100).

## Patentansprüche

1. Detektionsvorrichtung (1) eines elektrischen Gleich- oder Wechselfehlerstroms (If), die aufweist:
- einen Gleichstromsensor (10), der enthält:
- einen ersten Magnetkreis (11) der von mindestens einem Stromleiter (2) durchquert wird, in dem der zu detektierende elektrische Fehlerstrom (If) fließt, wobei der Stromleiter (2) einen ersten Primärkreis (12) formt,
- eine erste Wicklung (13), die auf den ersten Magnetkreis (11) gewickelt ist, um einen ersten Sekundärkreis zu formen und ein für den Fehlerstrom (If) repräsentatives erstes Signal (ls1) zu liefern, und
- einen Generator (14), der an die Klemmen der ersten Wicklung (13) angeschlossen ist, um einen Erregerwechselstrom (Ig) des ersten Magnetkreises (11) zu erzeugen und ein Magnetfeld in den ersten Magnetkreis (11) zu induzieren,
- einen Messkreis des Stroms (20), und
- einen Wechselstromsensor (30), der einen zweiten Magnetkreis (31) aufweist, auf den eine zweite Wicklung (33) gewickelt ist, um ein für den im Stromleiter (2) fließenden Fehlerstrom (If) repräsentatives zweites Signal (Is2) zu liefern,
**dadurch gekennzeichnet, dass**
die zweite Wicklung (33) mit der ersten Wicklung (13) in Reihe geschaltet ist, damit das erste Signal und das zweite Signal (Is1, Is2), die für den im Stromleiter (2) fließenden Fehlerstrom (If) repräsentativ sind, phasengleich sind, und mit dem Messkreis des Stroms (20) in Reihe geschaltet ist, wobei der zweite Magnetkreis (31) vom Stromleiter (2) durchquert wird, in dem der elektrische Fehlerstrom (If) fließt, wobei der Stromleiter (2) einen zweiten Primärkreis (32) formt, und
der Generator (14) eingerichtet ist, damit das Magnetfeld abwechselnd in einer gegebenen Richtung und dann in Gegenrichtung den ersten Magnetkreis (11) sättigt.

2. Vorrichtung nach Anspruch 1, **dadurch gekennzeichnet, dass**, da der erste Primärkreis (12) eine erste Anzahl von Primärwindungen (Np1) aufweist, die erste Wicklung (13) eine erste Anzahl von Sekundärwindungen (Ns1) aufweist, der zweite Primärkreis (32) eine zweite Anzahl von Primärwindungen (Np2) aufweist und die zweite Wicklung (33) eine zweite Anzahl von Sekundärwindungen (Ns2) aufweist, das Verhältnis der ersten Anzahl von Primärwindungen (Np1) zur ersten Anzahl von Sekundärwindungen (Ns1) im Wesentlichen gleich dem Verhältnis der zweiten Anzahl von Primärwindungen (Np2) zur zweiten Anzahl von Sekundärwindungen (Ns2) ist.

3. Vorrichtung nach einem der vorhergehenden Ansprüche, **dadurch gekennzeichnet, dass** der Messkreis des Stroms (20) einen Messwiderstand (Rm) enthält, um ein Messsignal (21) zu liefern.

4. Vorrichtung nach dem vorhergehenden Anspruch, **dadurch gekennzeichnet, dass** die zweite Wicklung (33) und der Messwiderstand (Rm) eingerichtet sind, um ein erstes Tiefpassfilter einer Grenzfrequenz zwischen 1 und 1000 Hz zu bilden.

5. Vorrichtung nach einem der vorhergehenden Ansprüche, **dadurch gekennzeichnet, dass** ein zweites Tiefpassfilter (40) an den Messkreis des Stroms (20) angeschlossen ist, um ein gefiltertes Signal (41) zu liefern, das für die Niederfrequenzkomponente des Fehlerstroms (If) repräsentativ ist.

6. Vorrichtung nach dem vorhergehenden Anspruch, **dadurch gekennzeichnet, dass** das zweite Tiefpassfilter (40) die Frequenzen so filtert, dass sie einem menschlichen Empfindlichkeitsmaß gegenüber dem elektrischen Strom folgen.

7. Vorrichtung nach einem der Ansprüche 5 oder 6, **dadurch gekennzeichnet, dass** das zweite Tiefpassfilter (40) eine Grenzfrequenz (Fc1) zwischen 30 und 300 Hz hat.

8. Vorrichtung nach einem der Ansprüche 5 bis 7, **dadurch gekennzeichnet, dass** ein erster Komparator (50) am Ausgang des zweiten Tiefpassfilters (40) angeschlossen ist, um ein erstes Fehlersignal (51) zu liefern, wenn das gefilterte Signal (41) höher ist als eine erste Schwelle (S1).

9. Vorrichtung nach einem der vorhergehenden Ansprüche, **dadurch gekennzeichnet, dass** ein Signalpegel-Messkreis (60) an den Messkreis des Stroms (20) angeschlossen ist, um ein für den maximalen Pegel (61) des Messsignals (21) repräsentatives Signal zu liefern.

10. Vorrichtung nach dem vorhergehenden Anspruch, **dadurch gekennzeichnet, dass** ein zweiter Komparator (70) am Ausgang des Signalpegel-Messkreises (60) angeschlossen ist, um ein zweites Fehlersignal (71) zu liefern, wenn der maximale Pegel des vom zweiten Komparator (70) gelieferten Signals höher ist als eine zweite Schwelle (S2).

11. Vorrichtung nach einem der vorhergehenden Ansprüche, **dadurch gekennzeichnet, dass** das ein Detektionskreis einer anormalen Frequenz (80) mit der ersten Wicklung (13) verbunden ist, um die Frequenzkomponenten des Erregerwechselstroms (Ig) zu messen und ein drittes Fehlersignal (81) zu liefern, wenn mindestens eine Frequenzkomponente des Erregerwechselstroms (Ig) zwischen einer vorgegebenen niederen Grenzfrequenz (FL_BF) und hohen Grenzfrequenz (FL_HF) liegt.

12. Vorrichtung nach dem vorhergehenden Anspruch, **dadurch gekennzeichnet, dass** die niedere Grenzfrequenz (FL_BF) zwischen 1kHz und 10 kHz liegt, und die hohe Grenzfrequenz (FL_HF) zwischen 20 kHz und 200 kHz liegt.

13. Vorrichtung nach einem der vorhergehenden Ansprüche, **dadurch gekennzeichnet, dass** der Gleichstromsensor (10) mindestens einen Shunt-Spannungsregler (15) aufweist, um eine Spannungserhöhung an den Klemmen der ersten Wicklung (13) zu begrenzen, wenn der im Stromleiter (2) fließende Fehlerstrom (If) eine vorgegebene Spitzenamplitude (ISpitze) überschreitet.

14. Schutzmodul gegen einen elektrischen Fehler (100), das aufweist:
- mindestens eine vorgeschaltete Anschlussklemme (101) an eine Stromleitung (7) eines Stromnetzes und mindestens eine nachgeschaltete Anschlussklemme (102) an eine Energieverteilungsleitung (8),
**dadurch gekennzeichnet, dass** es aufweist:
- mindestens einen Stromleiter (2), der zwischen der vorgeschalteten Anschlussklemme (101) und der nachgeschalteten Anschlussklemme (102) angeschlossen ist,
- eine Detektionsvorrichtung (1) eines in dem mindestens einen Stromleiter (2) fließenden elektrischen Fehlerstroms (If) nach einem der Ansprüche 1 bis 13, und
- ein Verarbeitungsmodul (110) verbunden:
- mit einem ersten Komparator (50), um ein erstes Fehlersignal (51) zu empfangen,
- mit einem zweiten Komparator (70), um ein zweites Fehlersignal (71) zu empfangen, und
- mit einem Detektionskreis anormaler Frequenz (80), um ein drittes Fehlersignal (81) zu empfangen,
wobei das Verarbeitungsmodul (110) eingerichtet ist, um ein Alarm- oder Steuersignal (111) zu liefern, wenn das Verarbeitungsmodul (110) ein erstes oder ein zweites oder ein drittes Fehlersignal (51, 71, 81) empfängt.

15. Elektrisches Schutzgerät (120), das aufweist:
- mindestens ein Anschlusselement (121) an das Stromnetz und mindestens ein Anschlusselement (122) an eine Energieverteilungsleitung (8),
- einen Stromschalter (140), der mit mindestens einem Stromleiter (2) in Reihe geschaltet ist, zwischen dem Anschlusselement (101) an das Stromnetz und dem Anschlusselement (102) an die Energieverteilungsleitung, wobei der Stromschalter (140) eingerichtet ist, um ein Fließen eines elektrischen Gleichstrom- oder Wechselstrom-Fehlerstroms (If) in dem mindestens einen Stromleiter (2) zu erlauben oder zu unterbrechen,
- einen Öffnungssteuermechanismus (131) des Stromschalters (140), und
- einen Aktor (135), der eingerichtet ist, um den Öffnungssteuermechanismus (131) zu betätigen,
**dadurch gekennzeichnet, dass** das elektrische Schutzgerät (120) ein Schutzmodul gegen einen elektrischen Fehler (100) nach dem vorhergehenden Anspruch aufweist, um einen elektrischen Fehlerstrom ( If) zu detektieren, der in dem mindestens einen Stromleiter (2) fließt, wobei das elektrische Schutzmodul (100) an den Aktor (135) angeschlossen ist, um die Öffnung des Stromschalters (140) zu steuern, wenn ein Alarm- oder Steuersignal (111) vom Schutzmodul (100) geliefert wird.

## Claims

1. Device (1) for detecting a direct or alternating electric fault current (If), comprising:
- a direct current sensor (10), comprising:
- a first magnetic circuit (11) which has at least one current conductor (2) through which the electric fault current (If) to be detected flows passing through it, said current conductor (2) forming a first primary circuit (12),
- a first winding (13) coiled about said first magnetic circuit (11) in order to form a first secondary circuit and produce a first signal (Is1) which is representative of the fault current (If), and
- a generator (14) connected to the terminals of the first winding (13) in order to generate an alternating current (Ig) for exciting the first magnetic circuit (11) and to induce a magnetic field in the first magnetic circuit (11), and
- a current measurement circuit (20), and
- an alternating current sensor (30), comprising a second magnetic circuit (31) about which a second winding (33) is coiled in order to produce a second signal (Is2) which is representative of the fault current (If) flowing through the current conductor (2),
**characterized in that**
said second winding (33) is connected in series with the first winding (13) so that the first signal and the second signal (Is1, Is2) which are representative of the fault current (If) flowing through the current conductor (2) are in phase, and with the current measurement circuit (20), the second magnetic circuit (31) having the current conductor (2) through which the electric fault current (If) flows passing through it, said current conductor (2) forming a second primary circuit (32), and
said generator (14) is arranged in order for the magnetic field to saturate the first magnetic circuit (11) alternately in a given direction and then in the opposite direction.

2. Device according to Claim 1, **characterized in that**, with the first primary circuit (12) comprising a first number of primary turns (Np1), the first winding (13) comprising a first number of secondary turns (Ns1), the second primary circuit (32) comprising a second number of primary turns (Np2) and the second winding (33) comprising a second number of secondary turns (Ns2), the ratio of the first number of primary turns (Np1) to the first number of secondary turns (Ns1) is substantially equal to the ratio of the second number of primary turns (Np2) to the second number of secondary turns (Ns2).

3. Device according to one of the preceding claims, **characterized in that** the current measurement circuit (20) comprises a measurement resistor (Rm) in order to produce a measurement signal (21).

4. Device according to the preceding claim, **characterized in that** the second winding (33) and the measurement resistor (Rm) are arranged in order to form a first low-pass filter with a cut-off frequency of between 1 and 1000 Hz.

5. Device according to one of the preceding claims, **characterized in that** a second low-pass filter (40) is connected to the current measurement circuit (20) in order to produce a filtered signal (41) which is representative of the low-frequency component of the fault current (If).

6. Device according to the preceding claim, **characterized in that** the second low-pass filter (40) filters the frequencies so as to follow a profile of human sensitivity to electric current.

7. Device according to one of Claims 5 and 6, **characterized in that** the second low-pass filter (40) has a cut-off frequency (Fc1) of between 30 and 300 Hz.

8. Device according to any one of Claims 5 to 7, **characterized in that** a first comparator (50) is connected at the output of the second low-pass filter (40) in order to deliver a first fault signal (51) when the filtered signal (41) is above a first threshold (S1).

9. Device according to any one of the preceding claims, **characterized in that** a signal level measurement circuit (60) is connected to the current measurement circuit (20) in order to produce a signal (61) which is representative of the maximum level of the measurement signal (21).

10. Device according to the preceding claim, **characterized in that** a second comparator (70) is connected at the output of the signal level measurement circuit (60) in order to deliver a second fault signal (71) when the maximum level of the signal delivered by the second comparator (70) is above a second threshold (S2).

11. Device according to any one of the preceding claims, **characterized in that** an abnormal frequency detection circuit (80) is connected to the first winding (13) in order to measure the frequency components of the alternating excitation current (Ig) and to produce a third fault signal (81) when at least one frequency component of said alternating excitation current (Ig) is between a predefined lower limit frequency (FL_BF) and a predefined upper limit frequency (FL_HF).

12. Device according to the preceding claim, **characterized in that** the lower limit frequency (FL_BF) is between 1 kHz and 10 kHz and the upper limit frequency (FL_HF) is between 20 kHz and 200 kHz.

13. Device according to any one of the preceding claims, **characterized in that** the direct current sensor (10) comprises at least one shunt voltage regulator (15) in order to cap a rise in voltage across the terminals of the first winding (13) when the fault current (If) flowing through the current conductor (2) exceeds a predefined peak amplitude (Ipeak).

14. Module (100) for protecting against an electrical fault, comprising:
- at least one terminal (101) for connecting upstream to a current line (7) of an electrical grid and at least one terminal (102) for connecting downstream to a power distribution line (8),
**characterized in that** it comprises:
- at least one current conductor (2) connected between the upstream connection terminal (101) and the downstream connection terminal (102),
- a device (1) for detecting an electric fault current (If) flowing through the at least one current conductor (2) according to any one of Claims 1 to 13, and
- a processing module (110) connected:
- to a first comparator (50) in order to receive a first fault signal (51),
- to a second comparator (70) in order to receive a second fault signal (71), and
- to an abnormal frequency detection circuit (80) in order to receive a third fault signal (80),
said processing module (110) being arranged in order to produce a warning or control signal (111) when said processing module (110) receives a first or a second or a third fault signal (51, 71, 81).

15. Electrical protection unit (120), comprising:
- at least one element (121) for connecting to the electrical grid and at least one element (122) for connecting to a power distribution line (8),
- an electrical switch (140), connected in series with at least one current conductor (2), between the element (101) for connecting to the electrical grid and the element (102) for connecting to the power distribution line, said electrical switch (140) being arranged in order to allow a direct or alternating electric fault current (If) to flow, or stop it flowing, through the at least one current conductor (2),
- a mechanism (131) for controlling the electrical switch (140) so as to open, and
- an actuator (135) arranged in order to actuate the opening control mechanism (131),
**characterized in that** said electrical protection unit (120) comprises a module (100) for protecting against an electrical fault according to the preceding claim in order to detect an electric fault current (If) flowing through the at least one current conductor (2), said electrical protection module (100) being connected to the actuator (135) in order to control the electrical switch (140) so as to open when a warning or control signal (111) is produced by the protection module (100).
